# EUROPEAN PATENT APPLICATION

(11) **EP 0 665 499 A2**
(43) Date of publication of application: **02.08.1995**
(21) Application number: 95300181.5
(22) Date of filing: 12.01.1995
(51) Int. Cl.: G06F 12/08, G06F 3/06

(54) **Hierarchic data storage system**

(30) Priority: 27.01.1994 GB 9401522
(71) Applicant: INTERNATIONAL COMPUTERS LIMITED, Putney, London, SW15 1SW (GB)
(72) Inventor: Gold, Stephen, Camberley, Surrey (GB); Hilditch, Albert Stephen, Wokingham, Berkshire RG11 1WE (GB)
(74) Representative: Guyatt, Derek Charles

(57) **Abstract**

A computer system comprises a host computer (10) and a hierarchical data storage system (11) connected to the host computer. The hierarchical data storage system comprises a magnetic disk store (13) and an optical disk store (14) having a greater capacity and lower performance than the magnetic disk store. A storage controller (15) manages access to data in the stores, operating the magnetic disk store as a set-associative cache store for caching data from said optical disk store. A disk store interface (23) (e.g. SCSI) connects the storage controller means to the host computer. Thus, the hierarchical data storage system presents a standard disk interface to the host, and can therefore be accessed by a standard operating system.

## Description

### Background to the Invention

This invention relates to hierarchic data storage systems.

A hierarchic data storage system comprises a plurality of levels of storage, with each successive level having a greater capacity, lower cost and lower performance (i.e. slower access time) than the level above it. For example, the levels in a data storage hierarchy may comprise magnetic disks, optical disks, and magnetic tape.

In such a system, data that is currently being used is held in the highest (fastest) level, for rapid access. Data that has not been accessed recently is moved down to a lower (slower) level, to make room for new data in the higher level.

There are a number of problems with known storage systems:
1) Changes are needed to the operating system kernel. Each separate operating system and each separate operating system release need separate ports of the software.
2) Since most relational database management systems do not use the standard file systems but implement their own on top of raw device drivers, their data cannot be hierarchically managed.
3) Standard hierarchic storage systems cannot backup their data efficiently since it is mostly stored on slow, sometimes sequential access, media.
4) Standard hierarchic storage systems are difficult to install, manage and performance tune, thus adding to the end users costs.
5) Standard hierarchic storage systems impose a heavy overhead on the operating system of the host computer, since it is necessary for the operating system to manage the transfer of data between the levels of the storage system.

The object of the present invention is to alleviate these problems.

### Summary of the Invention

According to the invention there is provided a computer system comprising: a host computer and a hierarchical data storage system connected to the host computer, said hierarchical data storage system comprising:
(a) a first level of storage;
(b) a second level of storage having a greater capacity and lower performance than said first level of storage;
(c) storage controller means, connected to said first and second levels of storage, for managing access to data in said first and second levels of storage; and
(d) disk store interface means for connecting said storage controller means to said host computer.

It can be seen that, because the data storage system presents a standard disk interface, it can be accessed by a standard operating system; the operating system does not need to be aware of the hierarchical nature of the storage system, and does not need to concern itself with management of the transfer of data between the levels of the hierarchy, or concern itself with backing up the data. The standard disk interface also allows hierarchic management of relational databases which do not use the standard file systems. Further, the act of off-loading hierarchic storage management onto dedicated storage management components increases the performance of the central processor(s).

### Brief Description of the Drawings

Figure 1 is a block diagram of a computer system including a hierarchic storage system in accordance with the present invention.

Figure 2 is a block diagram showing a storage controller in more detail.

Figure 3 is a flow chart showing the operation of the storage controller.

### Description of an Embodiment of the Invention

One embodiment of the invention will now be described by way of example with reference to the accompanying drawings.

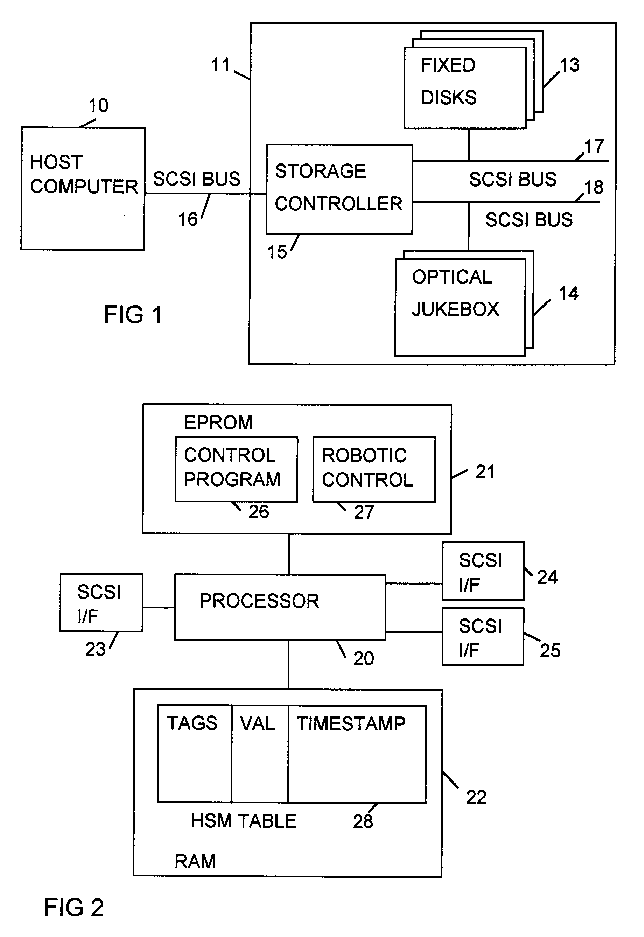

Referring to Figure 1, this shows a data processing system comprising a host computer 10, and an archival storage system 11. The archival storage system in this example comprises a two-level storage hierarchy. The upper level of this hierarchy comprises six fixed-disk magnetic disk drives 13, each having a storage capacity of 2 Gigabytes. The lower level of the hierarchy comprises two 128 Gigabyte optical jukeboxes 14. Each of these optical jukeboxes consists of a robotic mechanism for selecting one of a large number of optical disks, and inserting the selected disk in a drive mechanism, for reading or writing. The archival storage system also includes a storage controller 15 for managing the data in the disk drives 13 and optical jukeboxes 14. The storage controller is connected to the host computer 10, magnetic disk drives 13, and optical jukeboxes 14 by way of respective standard SCSI buses 16,17,18.

The archival storage system presents a standard SCSI disk interface to the host computer; that is, it appears to the host computer exactly as if it were a standard SCSI disk unit. The importance of this is that it means that the operating system in the host computer may be any operating system capable of handling SCSI disks, such as for example the UNIX operating system. No modification of the operating system is required to enable it to use the archival storage system; the hierarchical nature of the storage is completely transparent to the operating system.

The data is stored in the memory system in blocks, each block consisting of 4K bytes. Thus, each of the optical jukeboxes stores a total of 32M blocks. The data is mirrored, so that each jukebox holds a copy of the data. Each block has a 25-bit global block address, that uniquely identifies the block within the optical jukebox, according to a predetermined mapping scheme that maps each global block address on to a particular sector of a particular optical disk.

As will be described, the upper level of the hierarchy (comprising the magnetic disks) is organized as a 3-way set-associative cache, with each cache set holding 512K blocks of data. In other words, it is organized as 512K slots, each slot holding 3 data blocks. Each of the three cache sets is accessed using a different hashing algorithm. The data is mirrored at this level also, so that two copies of each data block are stored, on different disks. Data blocks are copied from the lower level (the optical jukeboxes) to the upper level on demand, using a LRU (least-recently-used) policy to decide which blocks are to be replaced.

Referring now to Figure 2, this shows the storage controller 15 in more detail. The storage controller comprises a processor chip 20, a programmable read-only memory (EPROM) 21, and a random-access memory (RAM) 22. The controller also includes three SCSI interface chips 23,24,25 for respectively interfacing with the three SCSI buses 16,17,18.

The EPROM 21 stores programs for the processor chip. These programs include a control program 26, for handling data access requests, and a robotic control program 27, for controlling the operation of the optical jukeboxes.

The RAM 22 holds a hierarchical storage management (HSM) table 28, containing an entry for each data block currently resident in the upper storage level. These entries are organised as three cache sets, each set containing 512K entries. Each entry consists of 2 bytes. The first byte contains a 6-bit tag value, and two validity bits, which indicate whether the two copies of the block in the lower level of the store are valid. The second byte contains a timestamp value, for use by the LRU mechanism.

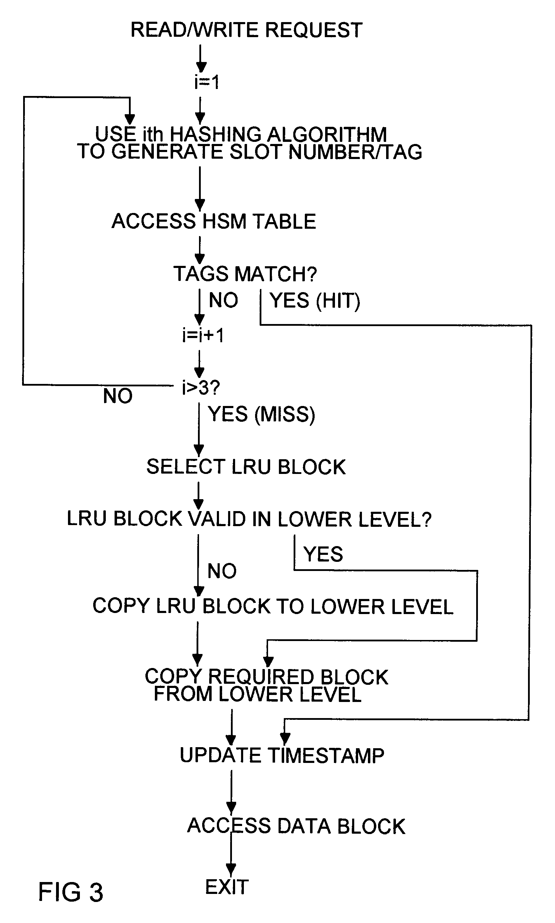

Referring now to Figure 3, this shows the operation of the control program, in response to a read/write request for accessing data from the store. It is assumed that the read/write request contains a 25-bit global block address, specifying a particular data block, and a 12-bit offset, indicating the location of the required data within that block.

The control program contains a loop, which is repeated for each of the three cache sets (i=1 to 3). Each time through the loop, a different hashing algorithm is used to hash the 25-bit block number, to produce a 19-bit slot number, and a 6-bit tag value. The slot number is then used to address the HSM table in the RAM, to access an entry from cache set i. The tag value generated by the hashing algorithm is compared with the tag value stored in this entry. If these tag values are equal there is a cache HIT, and so the program breaks out of the loop. If no HIT is found in any of the sets, a cache MISS has occurred.

In the case of a HIT, the following actions are performed. The required data block is accessed from the upper level of the store (the magnetic disk drives), using the set number and slot number to provide the address of the data block in the upper level. The timestamp in the HSM table entry for this block is updated, to indicate that it is now the most recently used block. If this is a write access, the validity bits are reset, to indicate that the block is no longer valid in the lower level (the optical jukeboxes).

In the case of a MISS, the following actions are performed. The timestamps of the three entries that were accessed are compared, and the one with the oldest timestamp is selected, corresponding to the least-recently used data block in this slot. If either of the validity bits of this entry indicates that the data is not valid in the lower level of the store (the optical jukeboxes), the corresponding data block is then read from the upper level (the magnetic disks) and copied to the lower level. The data block specified in the read/write request is then read from the lower level, and copied into the upper level. The data is then accessed in the upper level, as described above for the case of a HIT.

As described above, three independent hashing algorithms are used, for addressing the three sets in the upper level of the store. These three hashing algorithms are conveniently implemented by means of the hashing mechanism described in British patent No GB2240413, which uses a random matrix and matrix multiplication to generate a number of independent hash addresses.

It will be appreciated that many modifications to the system described above are possible without departing from the scope of the present invention. For example, further levels may be provided in the storage hierarchy, e.g. a three-level hierarchy could be constructed using magnetic tape stackers to provide a further level below the optical jukeboxes. Moreover, instead of providing a SCSI disk interface, the storage system could present a different form of low-level interface to the host processor.

## Claims

1. A computer system comprising: a host computer (10) and a hierarchical data storage system (11) connected to the host computer, said hierarchical data storage system comprising:
(a) a first level of storage (13);
(b) a second level of storage (14) having a greater capacity and lower performance than said first level of storage; and
(c) storage controller means (15), connected to said first and second levels of storage, for managing access to data in said first and second levels of storage;
characterised by disk store interface means (23) for connecting said storage controller means to said host computer.

2. A system according to Claim 1 wherein said disk store interface means comprises a SCSI (Small Computer System Interface) disk interface.

3. A system according to Claim 1 or 2 wherein said first level of storage comprises a magnetic disk store, and said second level of storage comprises an optical disk store.

4. A system according to any preceding claim wherein each of said first and second levels of storage holds a plurality of data blocks, and wherein said storage controller means includes a random access memory holding a table for indicating in which of said levels each said data block currently resides.

5. A system according to Claim 4 wherein said table comprises a hash-addressed set-associative table.

6. A hierarchical data storage system comprising:
(a) a magnetic disk store (13); and
(b) an optical disk store (14);
characterised by storage controller means (15) for operating said magnetic disk store as a set-associative cache store for caching data from said optical disk store.

7. A system according to Claim 6 wherein each of said first and second levels of storage holds a plurality of data blocks, and wherein said storage controller means includes a random access memory holding a table for indicating in which of said levels each said data block currently resides.

8. A system according to Claim 7 wherein said table comprises a hash-addressed set-associative table.

9. A computer system comprising a host computer and a hierarchical data storage system in accordance with any one of claims 6 to 8.
